Europäisches Patentamt

European Patent Office

Office européen des brevets

(19)

(11) Publication number: **0 193 899**
**B1**

# EUROPEAN PATENT SPECIFICATION

(45) Date of publication of the patent specification:
**13.06.90**

(51) Int. Cl.⁵: **G01S 7/52**, G01S 15/89,
H03D 7/00

(21) Application number: **86102658.1**

(22) Date of filing: **28.02.86**

(54) Tissue signature tracking transceiver having upconverted if amplification.

(30) Priority: **04.03.85 US 707584**

(43) Date of publication of application:
**10.09.86 Bulletin 86/37**

(45) Publication of the grant of the patent:
**13.06.90 Bulletin 90/24**

(84) Designated Contracting States:
**DE FR GB IT NL SE**

(73) Proprietor: **DYMAX CORPORATION, 136 Gamma Drive, Pittsburgh, PA 15238(US)**

(72) Inventor: **Matzuk, Terrance, deceased(US)**

(74) Representative: **EGLI-EUROPEAN PATENT ATTORNEYS, Widenmayerstrasse 5, D-8000 München 22(DE)**

(56) References cited:
US-A- 4 132 952
US-A- 4 197 750
US-A- 4 352 210
US-A- 4 442 715

IBM TECHNICAL DISCLOSURE BULLETIN, vol. 18, no. 5, October 1975, page 1539, New York, US; F.E. NOEL: "Voltage variable bandpass filter"
WESCON CONFERENCE RECORD, vol. 25, 1981, paper 24/4, pages 1-4, North Hollywood, US; W.E. SABIN: "Use of mixers in HF upconversion receivers/exciters"
FUNKSCHAU, vol. 48, no. 25, 3rd December 1976, pages 1109/69, 1110/70; "Funktechnische Arbeitsblätter Sp 82: "Überlagerungsempfänger - Wahl der Zwischenfrequenz"

(56) References cited: (continuation)
WESCON TECHNICAL PAPERS, vol. 14, 1970, paper 9/3, pages 1-4, North Hollywood, US; W.J. GEMULLA: "Parametric up-converters for low-noise broadband microwave receivers"

## Description

The present invention relates to medical ultrasound images, and in particular, to an ultrasound transceiver as defined in the preamble of claim 1. Such a transceiver is know from US-A 4 197 750.

For years, clinical ultrasound systems have incorporated either pulsed or continuous waves (CW) ultrasound techniques for imaging of tissue structure and flow of blood therethrough: Since the tissue investigated is a dispersive medium, signals transmitted into and thereafter reflected from tissue discontinuities suffers significant attenuation. That is, the greater the path taken by the acoustic signal within the subject, the greater the signal attenuated and otherwise changed. Previous systems have included compensation techniques such as time-controlled gain to provide correction for the anticipated attenuation by the signal in the subject tissue. Similarly, other correction techniques have been applied with varying degrees of success. Regardless of the correction techniques thus far, certain problems remain. Typical of these problems are the multiple reflections incurred between the surface of the specimen to be investigated, and the surface of the transducer thereof within the ultrasonic probe. Moreover, for the deeper signal penetration levels, the signal becomes excessively attenuated, often obscuring critical imaging information, and unfocussed.

One approach taken by the Applicant in previously filed application Serial No. 616,581 (corresponding to US-A 4 584 880 which is no prior art in the meaning of Art. 54(2)), entitled "Tissue Signature Tracking Tranceiver," incorporates the phenomenon of tissue signature analysis, wherein the transmitted pulse returns in a frequency-skewed form as a result of the transition through the tissue medium. However effective the system described therein may be, further improvements for technical and economic reasons are desired.

While the method described in the previous disclosure provides substantial improvement in overall image quality and in overall image uniformity, the following limitations exist arising from problems of implementation and economics:

1) When filter tracking is implemented, either filter inductance or capacitance must be modulated (e.g. saturable reactors or varactor diodes) to a very great extent because the required modulation of component values is the square of the frequency range. The resulting impedance variation is significant during the frequency tracking slew. If the percentage of frequency modulation could be reduced, the modulations of circuit component parameters could be also reduced.

2) The low-pass and high-pass cutoff frequencies must track to maintain a constant bandwidth.

3) The detector, regardless of its sophistication, must work with the baseband RF signal. Since the video frequency (envelope) information is so close to the lowest carrier frequency at the bottom of the echo-train, there is the practical problem of designing a broadband detector that has impressive rise-time performance but still suppresses carrier ripples (e.g., second harmonic). A detector capable of meeting the fast rise-time vs. low ripple criterion must contain high-order low-pass filters that represent some cost. If greater separation between the video (envelope) information and the carrier frequency were possible, one could obtain the required detector performance with a simple first-order low-pass filter after demodulation.

4) In the design of any practical receiver, given a simple, unshielded method of packaging, one is always faced with the question of how to design a receiver performing under extemely high gain conditions without uncontrolled feedback. If, for a given complexity and size of components, one could identify an alternative design with less crosstalk from the output back to RF front-end input, one would implement such a design for that reason alone.

5) Frequently the ultrasound pulser-receiver is required to be used in an imaging system that operates at several different ultrasound frequencies, such as 3.5, 5, and 7.5 MHz. Up until now, either broadband receivers had been used, or receivers with simple switched fixed-frequency filters have been used. A tissue-tracking receiver, operating in several ranges, of very simple design, would be highly desirable.

The ultrasound transceiver of the present invention provides a variable frequency, fixed-bandwidth reception of the signals reflected from tissue interfaces within the subject, providing improved rejection of multiple surface reflections, combined with improved signal resolution at the extreme penetration depth. The present invention further provides recovery of signals over a greater dynamic range than previously known.

Moreover, the present invention describes an ultrasound transceiver having a detected signal, which inherently deconvolves the interaction of the transmitted pulse signal from the transducer impulse response and the tissue reflection response, providing an enhanced axial signal resolution.

The apparatus according to the present invention as defined in the attached claims is embodied in hardware which provides these features, by way of a receiver which acquires and converts the received signals to a higher intermediate frequency having a constant bandwidth. The conversion to the higher frequency varies over time, such that the portion of the received spectrum changes, while maintaining the constant bandwidth requirement thus described. The particular details of the upconverted superheterodyne receiver used in the present invention provides enhanced signal processing and reduces both the false signals and economic costs for implementation. Thus the present invention provides the desired signal processing enhancements while providing a simple and cost-effective system.

These and other features of the present invention can be better understood by reading the following detailed description, taken together with the drawing, wherein:

Fig. 1 is a block diagram of the upconversion asynchronous transceiver according to the present invention;

Fig. 2 is a graph showing the signal components according to the frequency upconversion process according to the present invention;

Fig. 3 is a graph demonstrating the envelope detection according to one embodiment of the present invention;

Fig. 4 is a graph showing three modes of transducer operation; and

Fig. 5 is a graph showing the differing filter passbands according to the frequency ranges used according to one embodiment of the present invention.

The transceiver of the present invention is similar to the transceiver described by pending application Serial No. 616,581 by the same inventor, filed June 4, 1984 now US patent No 4 584 880 published April 29, 1986.

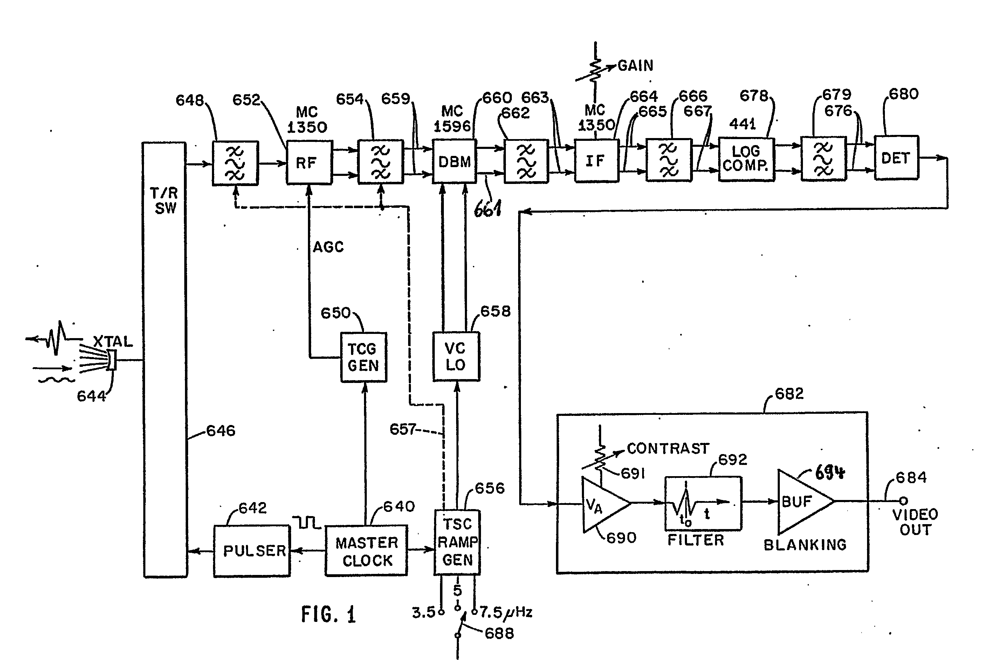

Fig. 1 shows a preferred functional design of the improvements comprising a pulse-receiver performing as summarized elsewhere. The functions of the AGI master clock 640, pulser 642, probe crystal 644, TR/ATR switch 646, bandpass filter 648, RF preamp 652, and time-controlled gain (TCG) ramp generator 650 are the same as in the design of the transceiver described in the application Serial No. 616,581. The TCG gain control is received by RF amplifier 652 typically a part number MC1350 by Motorola, Inc. The frequency spectrum of return echoes is only broadly confined by the broad bandpass filter 648 having a bandpass in the 2-7 MHz range. This filter acts as gross preselector whose function is mainly to prevent out-of-band (e.g. broadcast radio interference) signals from overloading amplifier 652 and causing intermodulation (IM) distortion in subsequent stages. A "tissue signature control" (TSC) ramp is generated at 656 and this signal frequency modulates a varactor-diode controlled voltage-controlled oscillator (VCO) 658 whose function in the system is to act as a local oscillator in an upconversion superheterodyne receiver. The output of VCO 658 is combined with the amplified RF echo signal at leads 659 at balanced modulator 660, typically part number MC1596 by Motorola, Inc., to produce sum-and-difference-frequency signals at point 664. A balanced modulator is used as the mixer stage because this method produces sum-and-difference components and suppresses the local oscillator in its output signal at leads 661 without the need for band-reject or notch filters. The upconverted signals at point 661 are applied to bandpass filter 662 that passes the difference frequency while rejecting the sum frequency. The output at leads 663 from this bandpass filter is fed into the "intermediate frequency" amplifier 664, also an MC1350, (a term borrowed from typical down-conversion superheterodyne receivers). The output at leads 665 is applied to a bandpass filter 666 identical to filter 662. The purpose of the second filter 666 is to steepen the dropoff rate of the skirts of the filter function of 662 so as to maximize the rejection of the sum frequencies. The output 667 is applied to log compressor 678, typically a part number 441 by Texas Instruments Corp., to video detector 680, and the output is deconvolved by circuit 682, resulting in the "analog video output" 684. The circuit 682 includes an amplifier 690 having a gain adjustment to provide contrast control. The subsequent filter 692 provides the deconvolution time function indicated within block 692 to provide image signal enhancement. The signal is buffered by amplifier 694, which also receives a blanking signal to inhibit the output video signal during the scan retrace time. It is important that filters 662 and 666 reject the sum frequency signal as improved sum frequency signal rejection greatly simplifies the problem of performing optimum envelope detection at 680 and deconvolution at 682.

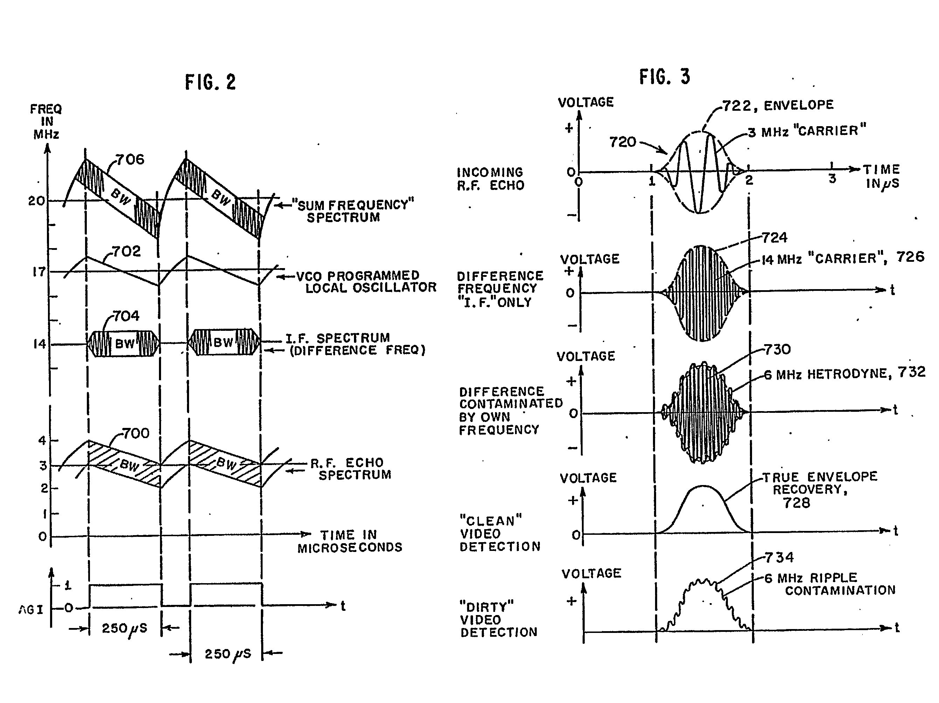

The frequency upconversion process will be modelled in order to appreciate the importance of adequate sum frequency rejection, shown in Fig. 2. The descending echo spectrum 700 is mixed with a descending local oscillator frequency 702 in the neighboroood of 17 MHz to produce a constant "intermediate frequency" spectrum 704 at the difference frequency of 14 MHz. The sum frequency spectrum 706, occurring at 19-21 MHz should be rejected from the IF amplification process. Otherwise a heterodyne in the neighborhood of 6 MHz will appear in the detector output.

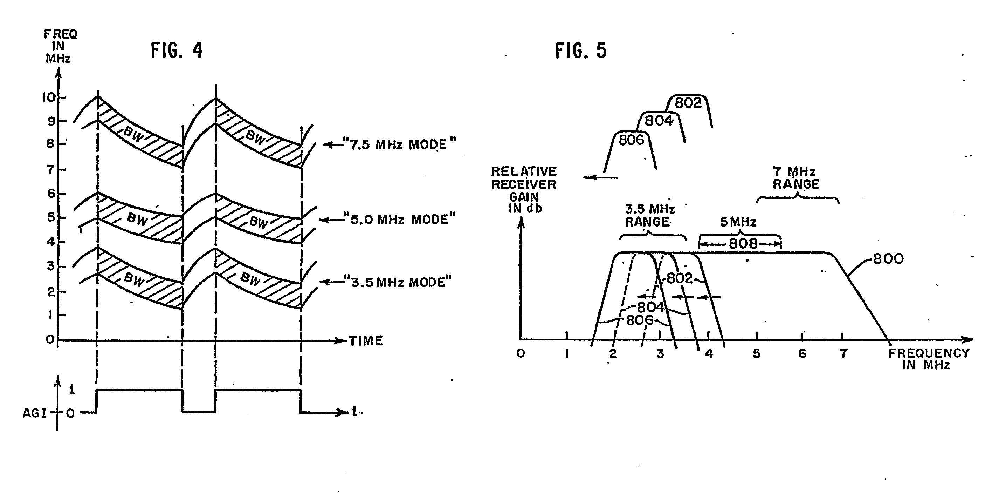

Fig. 3 clarifies these events. A typical single incoming RF echo signal 720 will have a 3-MHz carrier frequency and a duration of 1 microsecond. The video, or picture envelope information (pixel detail) is indicated by 722. The upconverted equivalent of 720, filtered to pass only the difference frequency is indicated as 724. The significance of the waveform 724 is that it contains a perfect reconstruction of the original envelope 722 and a high frequency carrier 726 of 14 MHz. Such a waveform, passing through a simple detector, can easily produce a nearly perfect video representation of the original envelope (728). If the sum frequency component enters the IF amplifier, the resulting waveform 730 produces a 6-MHz heterodyne 732, which leads to a "dirty" detection 734 comprising 6 MHz ripple content. The detector output 728 or 734 must be free of ripple content, at either 6 or 17 MHz, because the post-processing deconvolution has the effect of preemphasizing high-frequency ripple components in the detector output. However, there is less space and cost involved in improving the IF bandpass curve to steepen the skirts than to employ high-order lowpass filters within the detector stage. Also, by using more bandpass filtering at the IF level, there is better rejection of residual local oscillator signal. This is important because presence of the local oscillator at point 676 (of Fig. 1) can pre-bias the demodulator 680 (of Fig. 1), thereby artificially masking signal detection in the -30 dB range because of the continuously present oscillator feedthrough. The difference signal is used rather than the sum signal because the oscillator residuals are higher in frequency than the IF frequency, hence the oscillator feedthrough is more easily suppressed. An upconversion receiver is used (rather than the customary downconversion type) because true envelope reconstruction with a very high ripple frequency (2 x 14 MHz) is produced in a very direct way, and the filtering is much more economical because fewer filters are necessary and because the inductances at the IF frequency are smaller. Tuning is not critical because the entire receiver design is inherently broadbanded (approximately equal to 10 percent relative bandwidth). The employment of superheterodyne receiver of this type has the advantage that signals are shifted far away from the incoming RF spectrum early in the processing: the feedback problem is minimal compared to a straight baseband RF (or TRF) receiver or even compared to a conventional downconversion superheterodyne. Moreover, the upconversion receiver can be adapted to operate in several distinct frequency ranges (3.5, 5, 7.5 MHz of Fig. 4) by introducing a switchable DC bias into the TSC ramp waveform. This can be accomplished by the use of an operator switch 688 that acts on generator 656 (of Fig. 1).

In the event that a frequency range switch 688 is not used, the entire receiver will function with a single choice of ultrasound transducer frequency spectra, and the broad bandpass filters 648 or 654 can have their passband reduced only to cover the more limited range to minimize IM distortion. The choices available for the broad passband filters 648 or 654 are summarized in Fig. 5.

The frequency response 800 for the broad bandpass filters 648 or 654 for the general case (receiver switchable among three frequency ranges) is wide enough to admit every frequency capable of being tissue signature-processed. For example, if the receiver were to function for a 3.5-MHz crystal, the passbands 802, 804, 806 would be active through the entire receiver. When the receiver is switched to the 5-MHz mode, a similar set of moving passbands becomes active in region 808. Obviously the total frequency response 800 of filters 648 and 654 need be only as broad as selectable passbands employed through the manner of programming the local oscillator. it should be noted that programming the local oscillator 658 is a much more economical way of moving the passband frequency spectra of a receiver than dynamically tuning highpass and lowpass filter sections.

In the field of diagnostic medical ultrasound, this oscillator tuning after the preselector filter is generally permissible only because the ratio of stopband to passband amplitudes is lower than in the case of the "strong adjacent carrier" problem in commercial (short wave) communications systems, plagued with substantial signal fading problems.

The main source of "strong adjacent carrier" signal in ultrasound is the low-frequency component (1.6-2.3 MHz) present along with the high-frequency information spectra (3.5-4.8 MHz) of interest when imaging near echoes. Since even this strong low-frequency component rarely exceeds the amplitude of the high-frequency components, there is generally no significant problem in allowing all frequencies to slip through the preselector (648, 652, 654 of Fig. 1) and to feed the balanced modulator.

When considering ultrasound receiver designs with extremely wide dynamic range (approximately 60 dB at any given depth, approximately 85-105 dB over the entire echo-train range), the absolutely perfect suppression of intermodulation distortion arising from low-frequency components entering the modulator may become important. In order to achieve this higher merit of receiver performance, the upconversion receiver of Fig. 1 includes a "tracking preselector" (replacing 648, 652 of Fig. 1) with tunable RF circuitry being controlled by a signal on leads 657 from the ramp generator 656. By combining a narrow passband tunable preselector with the full upconversion feature, one in essence obtains the maximum possible dynamic range (reducing IM distortion and noise) for a given bandwidtth (rise time merit).

## Claims

1. An ultrasound transceiver comprising
- an ultrasound transducer (644),
- generator means (640, 642) for supplying to said transducer electrical excitation signals resulting in the transmission, into a medium under test, of ultrasonic signals of predetermined amplitude and of a selected spectral bandwidth,
- receiver means (648, 652, 654, 658-692) for processing the electric output signals generated by the transducer in response to ultrasonic echoes resulting from reflections in the medium of the transmitted ultrasonic signals, the receiver means comprising controllable frequency selection means (648, 654, 660, 662, 666) arranged to vary the center frequency of the receiver passband,
- control means (640, 656) arranged to control the variation of the center frequency of the receiver passband in such a way that this frequency follows the decrease of the center frequency of the ultrasonic echoes received after each transmission of an ultrasonic signal from increasing depths of penetration,
characterised in that
- the frequency selection means comprises
  a) a superheterodyne receiver circuit (658-666) including a mixer (660), an IF filter circuit (662, 666) having a passband above the frequency band of the electric output signals from the transducer, and a controllable local oscillator
  (658) arranged to supply to the mixer after each transmission of an ultrasonic signal a swept frequency signal of a sweep period corresponding to the time interval during which echoes are received after transmission of an ultrasonic signal,
  b) tunable bandpass filter means (648, 654) connected to the input of the superheterodyne receiver circuit and having a passband which is narrow in comparison with the frequency range across which the center frequency of the ultrasonic signals varies during said time interval,
- the control means being arranged to tune the bandpass filter means as a function of the center frequency of the received ultrasonic signals and to control the swept frequency signal so as to provide up-conversion of the electric output signals from the transducer into the passband of the IF-filter.

2. The ultrasound transceiver as claimed in claim 1, wherein said receiver circuit comprises a detector (682) and means responsive to the detector ouput signal for displaying an image according to said detector output signal.

## Patentansprüche

1. Ultraschallsender/-empfänger mit
- einem Ultraschallwandler (644),
- Generatoreinrichtungen (640, 642) zur Versorgung des Wandlers mit elektrischen Erregersignalen, die innerhalb eines zu prüfenden Mediums die Transmission von Ultraschallsignalen vorbestimmter Amplitude und einer ausgewählten spektralen Bandbreite bewirken,
- Empfangseinrichtungen (648, 652, 654, 658-692) zur Verarbeitung der durch den Wandler als Antwort auf Ultraschallechos erzeugten elektrischen Ausgangssignale, wobei die Echos von Reflexionen der transmittierten Ultraschallsignale in dem Medium herrühren, wobei die Empfangseinrichtungen steuerbare Frequenzwahleinrichtungen (648, 654, 660, 662, 666) umfassen, welche die Mittenfrequenz des Passbands des Empfängers verändern,
- Steuereinrichtungen (640, 656), die dazu dienen, die Veränderung der Mittenfrequenz des Passbands des Empfängers so zu steuern, daß diese Frequenz der bei zunehmender Eindringtiefe auftretenden Abnahme der Mittenfrequenz der Ultraschallechos folgt, die nach jeder Transmission eines Ultraschallsignales empfangen werden,
dadurch gekennzeichnet
- daß die Frequenzwahleinrichtungen aufweisen:
a) einen Superheterodyn-Empfängerkreis (658-666) mit einem Mischer (660), einem ZF-Filterkreis (662, 666) der ein Passband oberhalb des Frequenzbandes der elektrischen Ausgangssignale des Wandlers aufweist, und mit einem steuerbaren Überlagerungsoszillator (658), der so angeordnet ist, daß er dem Mischer nach jeder Transmission eines Ultraschallsignales ein gewobbeltes Frequenzsignal mit einer Wobbelperiode zuführt, die dem Zeitintervall entspricht, während dem Echos nach Transmission eines Ultraschallsignales erhalten werden,
b) abstimmbare Bandpassfiltereinrichtungen (648, 654), die mit dem Eingang des Superheterodyn-Empfängerkreises verbunden sind und ein Passband aufweisen, das schmal ist im Verhältnis zu dem Frequenzbereich, innerhalb dessen sich die Mittenfrequenz des Ultraschallsignals während des Zeitintervalles verändert,
- und daß die Steuereinrichtungen so angeordnet sind, daß sie die Bandpassfiltereinrichtungen in Abhängigkeit von der Mittenfrequenz des empfangenen Ultraschallsignals einstellen und daß sie das Wobbelfrequenzsignal steuern, um so eine Aufwärtsmischung des elektrischen Ausgangssignales von dem Wandler in das Passband des ZF-Filters vorzusehen.

2. Ultraschallsender/-empfänger nach Anspruch 1, dadurch gekennzeichnet, daß der Empfängerkreis einen Detektor (682) sowie Einrichtungen umfaßt, die auf das Ausgangssignal des Detektors ansprechen und ein dem Detektorausgangssignal entsprechendes Bild zeigen.

## Revendications

1. Un émetteur-récepteur ultrasonique comprenant
- un transducteur ultrasonique (644),
- des moyens émetteurs (640, 642) pour fournir audit transducteur des signaux électriques d'excitation provoquant la transmission, dans un milieu en cours d'essai, de signaux ultrasoniques d'amplitude prédéterminée et présentant une largeur de bande spectrale sélectionnée,
- des moyens récepteurs (648, 652, 654, 658 à 692) pour traiter les signaux électriques de sortie émis par le transducteur en réponse aux échos ultrasoniques résultant des réflexions dans le milieu des signaux ultrasoniques transmis, les moyens récepteurs comprenant des moyens de sélection de fréquence réglables (648, 654, 660, 662, 666) agencés pour faire varier la fréquence centrale de la bande passante du récepteur,
- des moyens de commande (640, 656) agencés pour commander la variation de la fréquence centrale de la bande passante du récepteur de telle façon que cette fréquence suive la diminution de la fréquence centrale des échos ultrasoniques reçus après chaque transmission d'un signal ultrasonique sur des profondeurs de pénétration croissantes,
caractérisé en ce que:
- les moyens de sélection de fréquence comportent:
a) un circuit récepteur superhétérodyne (658 à 666) comprenant un mélangeur (660), un circuit de filtre à fréquence intermédiaire (662, 666) présentant une bande passante supérieure à la bande de fréquence des signaux électriques de sortie en provenance du transducteur, et un oscillateur local réglable (658) agencé pour fournir au mélangeur, après chaque transmission d'un signal ultrasonique, un signal de fréquence balayée pour une période de balayage correspondant à l'intervalle de temps pendant lequel on reçoit des échos, après transmission d'un signal ultrasonique,
b) des moyens de filtre accordables de passage de bande (648, 654) reliés à l'entrée du circuit récepteur superhétérodyne et présentant une bande passante qui est étroite par comparaison avec la gamme de fréquence sur laquelle la fréquence centrale des signaux ultrasoniques varie au cours dudit intervalle de temps,
- les moyens de commande étant agencés pour accorder les moyens de filtre de passage de bande en fonction de la fréquence centrale des signaux ultrasoniques reçus et pour commander le signal de fréquence balayée, de façon à réaliser une superposition des signaux électriques de sortie en provenance du transducteur dans la bande passante du filtre à fréquence intermédiaire.

2. L'émetteur-récepteur ultrasonique selon la revendication 1, dans lequel ledit circuit récepteur comprend un détecteur (682) et des moyens sensibles au signal de sortie de détecteur, afin d'afficher une image correspondant audit signal de sortie de détecteur.

FIG. 1

EP 0 193 899 B1

FIG. 2

FIG. 3

EP 0 193 899 B1

FIG. 5

FIG. 4